(19) Europäisches Patentamt
European Patent Office
Office européen des brevets

(11) **EP 3 861 359 B1**

(12) **EUROPÄISCHE PATENTSCHRIFT**

(45) Veröffentlichungstag und Bekanntmachung des Hinweises auf die Patenterteilung:
**25.10.2023 Patentblatt 2023/43**

(21) Anmeldenummer: **19789585.7**

(22) Anmeldetag: **27.09.2019**

(51) Internationale Patentklassifikation (IPC):
***G01R 31/12*** *(2020.01)* ***G01R 31/52*** *(2020.01)*
***H02H 1/00*** *(2006.01)*

(52) Gemeinsame Patentklassifikation (CPC):
**G01R 31/52; H02H 1/0023;** G01R 31/1209;
G01R 31/1272

(86) Internationale Anmeldenummer:
**PCT/DE2019/100858**

(87) Internationale Veröffentlichungsnummer:
**WO 2020/069697 (09.04.2020 Gazette 2020/15)**

(54) **VERFAHREN ZUM BESTIMMEN EINES KURZSCHLUSSES MIT AUFTRETEN EINES LICHTBOGENS AN EINEM ELEKTRISCHEN LEITER**

METHOD FOR DETERMINING A SHORT CIRCUIT WITH THE OCCURRENCE OF AN ARC ON AN ELECTRICAL CONDUCTOR

PROCÉDÉ POUR DÉTERMINER UN COURT-CIRCUIT À L'APPARITION D'UN ARC ÉLECTRIQUE SUR UN CONDUCTEUR ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.10.2018 DE 102018124218**

(43) Veröffentlichungstag der Anmeldung:
**11.08.2021 Patentblatt 2021/32**

(73) Patentinhaber: **Hochschule für Technik und Wirtschaft Berlin**
**10318 Berlin (DE)**

(72) Erfinder:
• **GRÄF, Thomas**
**12459 Berlin (DE)**

• **MENGE, Matthias**
**12459 Berlin (DE)**
• **KÖLLING, Moritz**
**12459 Berlin (DE)**

(74) Vertreter: **Bittner, Thomas L.**
**Boehmert & Boehmert**
**Anwaltspartnerschaft mbB**
**Pettenkoferstrasse 22**
**80336 München (DE)**

(56) Entgegenhaltungen:
**DE-A1-102015 225 484**     **FR-A1- 2 827 675**
**US-A1- 2010 321 838**     **US-A1- 2018 074 112**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren sowie eine Anordnung zum Bestimmen eines Kurzschlusses mit Auftreten eines Lichtbogens an einem elektrischen Leiter.

Hintergrund

Beim Betrieb elektrischer Anlagen und Betriebsmittel stellt das Auftreten von Lichtbögen ein Gefährdungspotential dar. Die gefährdungsanalytische Beurteilung des Betriebs elektrischer Anlagen und Betriebsmittel fordert vom Betreiber Maßnahmen, die eine Gefährdung von Personen und Investitionsgütern auf ein absolutes Minimum reduzieren. Diese Maßnahmen sind regelmäßig auf Wirksamkeit zu überprüfen. Arbeiten und Tätigkeiten in unmittelbarer Nähe elektrischer Betriebsmittel erfordern grundsätzlich eine Vorabüberprüfung der Gefährdungssituation. Zu den auftretenden Effekten bei der Entstehung eines Lichtbogens zählen Lichtblitz, starker Stromanstieg, Knall und extreme Geräusche, toxische Rauchgase, Überdruck und Druckwellen, starke Hitzeentwicklung, mechanische Erschütterungen sowie Sekundärverletzungen.

Für das Erkennen und die Detektion von Lichtbögen, insbesondere in elektrischen Schaltanlagen, ist eine optische Erfassung der im ersten Augenblick entstehenden Strahlung bekannt. Die Auswertung der Strahlung, des Lichtspektrums sowie der Stromanstiegsgeschwindigkeit können als Kriterien dazu genutzt werden, ein weiteres Betriebsmittel zu aktivieren, das die Auswirkungen eines Lichtbogens reduzieren soll. Dieses zusätzliche Betriebsmittel kann beispielsweise die Strombahnen kurzschließen, so dass der Lichtbogen verlischt. Eine andere Maßnahme kann sein, den Kurzschlussstrom zu einem anderen Betriebsmittel zu kommutieren, indem die den Lichtbogenstrom führende Strombahn aufgesprengt wird und parallel dazu eine weitere Strombahn mit einem den Kurzschlussstrom ausschaltenden Betriebsmittel genutzt wird.

Bei bekannten Verfahren kann die Empfindlichkeit so hoch sein, dass das einfache Zünden eines Fotoblitzes bereits ausreicht, um die Lichtbogendetektion auszulösen und damit ganze Energieversorgungseinrichtungen abzuschalten. Verbesserungen hinsichtlich der Erkennung von Lichtbogenereignissen umfassen eine genaue Analyse des Lichtbogenspektrums sowie die Berücksichtigung der Stromanstiegsgeschwindigkeit. Lichtbögen und deren Lichtspektrum hängen vom verbrennenden Material ab. So unterscheidet sich das ausgesandte Lichtspektrum beim Verbrennen von Aluminium deutlich von dem beim Verbrennen von Kupfer.

Das Dokument US 2010 / 321838 A1 beschreibt eine Vorrichtung zum Detektieren eines Lichtbogens. Die Vorrichtung umfasst einen Fasersensor zum Erfassen von Eigenschaften eines Lichtbogens und einen Prozessor zum Verarbeiten von mindestens zwei Eigenschaften des Lichtbogens. Der Prozessor ist ferner dazu konfiguriert, ein Störlichtbogensignal zu erzeugen. Eine Schutzvorrichtung ist konfiguriert, um den Lichtbogen basierend auf dem Lichtbogenfehlersignal abzuschwächen.

In dem Dokument FR 2 827 675 A1 ist ein Netzüberwachungssystem offenbart, welches mit Ultraschallschwingungssensoren an einem Leiter charakteristische Signale eines Lichtbogens erfasst. Das System ist mit einem Hüllkurvendetektor und Filterung im Prozessor gebildet, wobei das Eingangssignal durch Vergleich mit einem adaptiven Schwellenwert in ein Lichtbogenanzeigesignal umgewandelt wird.

Das Dokument US 2018 / 074112 A1 betrifft eine Vorrichtung zum Detektieren eines Lichtbogens basierend auf einem analogen Ausgangssignal wenigstens eines Schallwellensensors.

In dem Dokument DE 10 2015 225 484 A1 ist ein Lichtbogendetektor für eine elektrische Schaltung offenbart. Der Lichtbogendetektor umfasst eine Mikrofoneinrichtung, welche dazu ausgelegt ist, bei einem Auftreffen eines akustischen Schalls auf der Mikrofoneinrichtung ein entsprechendes elektrisches Signal auszugeben, und eine Erkennungseinrichtung, welche dazu ausgelegt ist, anhand des von der Mikrofoneinrichtung empfangenen elektrischen Signals einen Lichtbogen zu erkennen, und gegebenenfalls ein entsprechendes Ausgabesignal auszugeben.

Zusammenfassung

Aufgabe der Erfindung ist es, ein Verfahren sowie eine Anordnung zum Bestimmen eines Kurzschlusses mit Auftreten eines Lichtbogens an einem elektrischen Leiter anzugeben, bei denen eine schnelle und frühe sowie sichere Bestimmung des Kurzschlusses erfolgt.

Zur Lösung sind ein Verfahren sowie eine Anordnung zum Bestimmen eines Kurzschlusses mit Auftreten eines Lichtbogens an einem elektrischen Leiter nach den unabhängigen Ansprüchen 1 und 12 geschaffen. Ausgestaltungen sind Gegenstand abhängiger Unteransprüche.

Nach einem Aspekt ist ein Verfahren zum Bestimmen eines Kurzschlusses mit Auftreten eines Lichtbogens an einem elektrischen Leiter geschaffen. Das Verfahren weist das Erfassen eines Messsignals für einen elektrischen Leiter mittels einer Sensoreinrichtung, das Vergleichen des Messsignals mit einem Referenzsignal mittels einer Auswerteeinrichtung und das Bestimmen eines Kurzschlusses mit Auftreten eines Lichtbogens mittels der Auswerteeinrichtung auf. Die Sensoreinrichtung weist einen Sensor auf. Das Bestimmen eines Kurzschlusses mit Auftreten eines Lichtbogens erfolgt unter Verwendung des Ergebnisses des Vergleichs des Messsignals mit dem Referenzsignal. Das Messsignal für den elektrischen Leiter und das Referenzsignal umfassen wenigstens eine Art von Messsignalen aus der folgenden Gruppe: Vibrationssignale und Schallsignale, welche durch eine Kraftwirkung der von dem elektrischen Leiter geführten elektrischen Spannung verursacht sind. Hierbei erfolgt das Bestimmen eines Kurzschlusses mit Auftreten eines Lichtbogens vor dem Auftreten des Lichtbogens.

Nach einem weiteren Aspekt ist eine Anordnung mit einem elektrischen Leiter, einer Sensoreinrichtung und einer Auswerteeinrichtung geschaffen. Die Sensoreinrichtung weist einen Sensor auf und ist eingerichtet, ein Messsignal für den elektrischen Leiter zu erfassen. Die Auswerteeinrichtung ist eingerichtet, das Messsignal mit einem Referenzsignal zu vergleichen und unter Verwendung des Ergebnisses des Vergleichs des Messsignals mit dem Referenzsignal einen Kurzschluss mit Auftreten eines Lichtbogens zu bestimmen. Das Messsignal für den elektrischen Leiter und das Referenzsignal umfassen wenigstens eine Art von Messsignalen aus der folgenden Gruppe: Vibrationssignale und Schallsignale, welche durch eine Kraftwirkung der von dem elektrischen Leiter geführten elektrischen Spannung verursacht sind. Die Auswerteeinrichtung ist eingerichtet, einen Kurzschluss mit Auftreten eines Lichtbogens vor dem Auftreten des Lichtbogens zu bestimmen.

Vibrationen im Sinne der Offenbarung sind mechanische Schwingungen von Körpern oder Stoffen. Umfasst sind periodische Schwingungen, aber auch aperiodische Signale wie zum Beispiel Dehnungen oder Stöße. Ferner kann der Sensor eingerichtet sein, weitere physikalische Messgrößen und/oder Messsignale zu erfassen. Das Messsignal kann sowohl ein Vibrationssignal als auch ein Schallsignal umfassen.

Bei einem Kurzschluss mit Auftreten eines Lichtbogens kann es sich allgemein um einen Kurzschluss handeln, bei dem bereits ein Lichtbogen entstanden ist. Alternativ kann ein Kurzschluss mit Auftreten eines Lichtbogens ein Kurzschluss sein, bei dem davon auszugehen ist, dass ein Lichtbogen entstehen wird. Bei dem Lichtbogen kann es sich um einen Längslichtbogen und/oder um einen Querlichtbogen handeln.

Der elektrische Leiter kann eine Wechselspannung führen. Alternativ oder zusätzlich kann der elektrische Leiter eine Gleichspannung führen. Beispielsweise kann der elektrische Leiter eine mit einer Gleichspannung überlagerte Wechselspannung führen. Eine Wechselspannung kann eine Spannung sein, welche um einen Gleichspanungs-Offset wechselt, ohne dass sich die physikalische Spannungsrichtung ändert.

Das Messsignal kann einen zeitlichen Verlauf eines Messwerts umfassen. Das Messsignal kann mehrere Einzelsignale umfassen. Beispielsweise kann das Messsignal mehrere zeitliche Verläufe von Messwerten umfassen. Die mehreren zeitlichen Verläufe von Messwerten können zum Beispiel über mehrere Kanäle der Sensoreinrichtung erfasst werden. Alternativ oder zusätzlich kann das Referenzsignal mehrere Einzelsignale umfassen.

Das Messsignal kann mit Hilfe eines faseroptischen Sensors erfasst werden. Insbesondere kann ein Vibrationssignal mithilfe eines faseroptischen Vibrationssensors erfasst werden. Faseroptische Sensoren zur Erfassung von Vibrationssignalen und/oder Schallsignalen können auch als faseroptisch-akustische Sensoren bezeichnet werden. Faseroptische Sensoren können eine Übertragung des Messsignals ermöglichen, die wenigstens streckenweise nicht an elektrisch leitendende Leitungen gebunden ist, und können deswegen insbesondere geeignet sein, in unmittelbarer Umgebung hochspannungsführender Betriebsmittel eingesetzt zu werden.

Bei dem faseroptischen Sensor kann es sich um einen Sensor handeln, bei dem sich ein erster Lichtweg durch einen ersten Faser-Lichtleiter durch Bewegung und/oder Verformung des ersten Faser-Lichtleiters ändert und der erste Lichtweg durch den ersten Faser-Lichtleiter mit einem zweiten Lichtweg verglichen wird, beispielsweise mittels Interferometrie. Der erste und der zweite Lichtweg können durch denselben Faser-Lichtleiter in entgegengesetzter Richtung führen. Über die Veränderung des ersten Lichtwegs in Bezug auf den zweiten Lichtweg kann auf eine Vibration des faseroptischen Vibrationssensors geschlossen werden.

Die Sensoreinrichtung kann direkt auf dem elektrischen Leiter angeordnet sein. Beispielsweise kann der Sensor direkt auf dem elektrischen Leiter angeordnet sein. Die Sensoreinrichtung kann an einer ein elektrisch leitendes Element des elektrischen Leiters direkt umgebenden Isolation angeordnet sein. Alternativ kann die Sensoreinrichtung direkt auf einem elektrisch leitenden Element des elektrischen Leiters angeordnet sein. Eine Anordnung der Sensoreinrichtung in der unmittelbaren Umgebung des elektrischen Leiters kann dadurch ermöglicht sein, dass der Sensor keine oder nur geringe Anteile elektrisch leitender Materialien aufweist. Beispielsweise kann die Anordnung der Sensoreinrichtung in der unmittelbaren Umgebung des elektrischen Leiters dadurch ermöglicht sein, dass der Sensor ein faseroptischer Sensor ist, der keine oder nur geringe Anteile elektrisch leitender Materialien aufweist.

Alternativ kann die Sensoreinrichtung, beispielsweise der Sensor, auf einem Übertragungselement angeordnet sein, welches eine mechanische Verbindung zwischen dem elektrischen Leiter und der Sensoreinrichtung herstellt, wobei das Übertragungselement eine Bewegung des elektrischen Leiters, beispielsweise eine Vibration und/oder Schall, auf die Sensoreinrichtung überträgt.

Bei dem elektrischen Leiter kann es sich um ein beliebiges bekanntes Element für das Führen einer elektrischen Spannung handeln. Beispielsweise kann der elektrische Leiter ein Kabel oder eine Stromschiene sein. So kann der elektrische Leiter eine Stromschiene in einem Schaltschrank sein.

Das Messsignal kann mit Hilfe von mehreren Sensoren erfasst werden. Die mehreren Sensoren können einen oder mehrere faseroptische Sensoren umfassen. Alternativ oder zusätzlich können die mehreren Sensoren wenigstens einen Sensor für die Erfassung eines Vibrationssignals und/oder eines Schallsignals umfassen, der kein faseroptischer Sensor ist. Beispielsweise können alle der mehreren Sensoren faseroptische Sensoren sein. Alternativ kann wenigstens einer der mehreren Sensoren ein faseroptischer Sensor sein und wenigstens ein weiterer der mehreren Sensoren kann ein Sensor eines anderen Sensortyps sein. Wenigstens einer der mehreren Sensoren kann ein Sensor für die Erfassung eines Vibrationssignals und/oder eines Schallsignals, der kein faseroptischer Sensor ist, und wenigstens ein weiterer der mehreren Sensoren kann ein Sensor eines anderen Sensortyps sein.

Die Sensoreinrichtung kann die mehreren Sensoren umfassen. Alternativ oder zusätzlich kann die Sensoreinrichtung eine Sensorelektronik-Einheit umfassen, beispielsweise zur Signalaufbereitung. Die Sensoreinrichtung kann eine Sensorelektronik-Einheit umfassen, die dem Sensor zugeordnet ist. Wenn die Sensoreinrichtung mehrere Sensoren umfasst, kann die Sensoreinrichtung mehrere Sensorelektronik-Einheiten umfassen, die jeweils einem der mehreren Sensoren zugeordnet sind. Alternativ kann eine Sensorelektronik-Einheit mehr als einem der mehreren Sensoren zugeordnet sein.

Die Sensoreinrichtung kann den Sensor, die mehreren Sensoren, die Sensorelektronik-Einheit und/oder die mehreren Sensorelektronik-Einheiten in einer Einheit umfassen, beispielsweise in einem Gehäuse. Alternativ kann die Sensoreinrichtung aus mehrere Einheiten bestehen, beispielsweise mit mehreren Gehäusen, welche die Sensoreinrichtung bilden, ohne eine zusammenhängende physische Einheit zu bilden.

Das Messsignal und/oder das Referenzsignal kann einen Verlauf einer Vibration und/oder einen Schallverlauf umfassen. Beispielsweise kann das Messsignal und/oder das Referenzsignal Datenpunkte eines Graphen einer Vibration oder von Schall umfassen. Das Messsignal und/oder das Referenzsignal kann einen Verlauf und/oder Informationen zu einem innerhalb eines zeitlichen Abschnitt und/oder Informationen bezüglich der Vibration und/oder des Schalls an einem Zeitpunkt umfassen. Das Messsignal und/oder das Referenzsignal kann Informationen bezüglich eines oder mehrerer Orte umfassen. Beispielsweise kann das Messsignal und/oder das Referenzsignal Signale von mehreren Sensoren umfassen.

Ein Kurzschluss mit Auftreten eines Lichtbogens kann bestimmt werden, wenn das Messsignal dem Referenzsignal nicht entspricht. Beispielsweise kann das Referenzsignal ein Signal sein, welches einen normalen Betriebszustand oder einen beliebigen Betriebszustand ohne Kurzschluss mit Auftreten eines Lichtbogens kennzeichnet. So kann das Referenzsignal einem Wechselspannungs-Betrieb des elektrischen Leiters entsprechen, bei der eine Vibration mit der doppelten Frequenz der Wechselspannung auftritt, ohne dass eine Anregung mit anderen Frequenzwerten oberhalb vorbestimmter Schwellenwerte vorliegt. Alternativ kann das Referenzsignal einem Gleichspannungs-Betrieb des elektrischen Leiters entsprechen, bei der keine Vibration oberhalb eines vorbestimmten Schwellenwerts vorliegt. Es kann bestimmt werden, dass das Messsignal dem Referenzsignal nicht entspricht, und daraufhin kann ein Kurzschluss mit Auftreten eines Lichtbogens bestimmt werden, wenn eine Differenz zwischen dem Messsignal und dem Referenzsignal und/oder ein einen Unterschied zwischen dem Messsignal und dem Referenzsignal kennzeichnender Unterschieds-wert einen festgelegten Wert überschreitet.

Ein Kurzschluss mit Auftreten eines Lichtbogens kann bestimmt werden, wenn das Messsignal dem Referenzsignal entspricht. Das Referenzsignal kann ein Signal sein, welches kennzeichnend für einen Kurzschluss-Zustand bei einem Kurzschluss mit Auftreten eines Lichtbogens ist. Es kann bestimmt werden, dass das Messsignal dem Referenzsignal entspricht, und daraufhin kann ein Kurzschluss mit Auftreten eines Lichtbogens bestimmt werden, wenn eine Differenz zwischen dem Messsignal und dem Referenzsignal und/oder ein einen Unterschied zwischen dem Messsignal und dem Referenzsignal kennzeichnender Unterschiedswert einen festgelegten Wert nicht überschreitet.

Das Messsignal und das Referenzsignal können anhand eines jeweiligen Merkmals des Messsignals und des Referenzsignals verglichen werden. Das Vergleichen des Messsignals mit dem Referenzsignal kann ausschließlich das Vergleichen von Merkmalen umfassen. Beispielsweise kann ein Kurzschluss mit Auftreten eines Lichtbogens bestimmt werden, wenn eine vorherrschende Frequenz, zum Beispiel die Frequenz mit der höchsten Schwingungsamplitude unter den in dem Messsignal enthaltenen Frequenzen, nicht einer durch das Merkmal des Referenzsignals angegebenen Frequenz entspricht. Alternativ kann das Merkmal ein den Kurzschluss-Zustand kennzeichnendes Zustandsmerkmal sein. Zusätzlich oder als Alternative kann das Merkmal Mindest-Anforderungen an ein Vibrations- und/oder Schallspektrum des Messsignals angeben. Beispielsweise kann das Merkmal ein minimaler und/oder ein maximaler Frequenzumfang bzw. Frequenzbereich, eine Maximal-Frequenz, eine Minimal-Frequenz, eine minimale und/oder eine maximale mittlere Amplitude oder eine minimale und/oder eine maximale Amplitude bei einer bestimmten Frequenz oder in einem bestimmten Frequenzbereich angeben.

Das Referenzsignal kann auf ein Merkmal beschränkt sein, welches dem Merkmal des Messsignals entspricht anhand dessen das Messsignal und das Referenzsignal verglichen werden. So kann das Messsignal beispielsweise einen Vibrations- und/oder Schallverlauf angeben, aus dem ein Merkmal bestimmt wird, welches mit dem Referenzsignal verglichen wird, welches ein entsprechendes Referenz-Merkmal, jedoch keinen vollständigen Vibrations- und/oder Schallverlauf, angibt.

Das Messsignal und das Referenzsignal können anhand eines jeweiligen Merkmals verglichen werden, welches mittels mindestens eines Mitglieds der Gruppe Fourier-Transformation, Kurzzeit-Fourier-Transformation, Wavelet-Transformation, Template-Matching, Spektrogramm, Amplitudenerfassung, Hüllkurvenerfassung und digitaler Filter bestimmt wird. Mittels Kurzzeit-Fourier-Transformation kann insbesondere ein Spektrogramm erzeugt werden. Ein Spektrogramm kann auch mit Hilfe einer Wavelet-Transformation erzeugt sein.

Das Merkmal des Messsignals kann durch die Auswerteeinheit bestimmt werden. Alternativ kann das Merkmal des Messsignals außerhalb der Auswerteeinheit, beispielsweise durch die Sensoreinrichtung, bestimmt werden. Als weitere Alternative kann das Merkmal des Messsignals teilweise durch die Auswerteeinheit und teilweise außerhalb der Auswerteeinheit bestimmt werden.

Ein Merkmal des Messsignals kann mit ein oder mehreren Merkmalen des Referenzsignals bzw. ein oder mehreren Referenz-Merkmalen verglichen werden. Beispielsweise kann ein Kurzschluss mit Auftreten eines Lichtbogens bestimmt werden, wenn ein Merkmal des Messsignals mit mehreren Merkmalen des Referenzsignals bzw. mehreren ReferenzMerkmalen übereinstimmt. Alternativ kann ein Kurzschluss mit Auftreten eines Lichtbogens bestimmt werden, wenn das Merkmal des Messsignals mit den mehreren Merkmalen des Referenzsignals bzw. den mehreren Referenz-Merkmalen nicht übereinstimmt. Als weitere Alternative kann ein Kurzschluss mit Auftreten eines Lichtbogens bestimmt werden, wenn das Merkmal des Messsignals mit wenigstens einem ersten der mehreren Merkmale des Referenzsignals bzw. wenigstens einem ersten Referenz-Merkmal nicht übereinstimmt und mit wenigstens einem zweiten der mehreren Merkmale des Referenzsignals bzw. einem zweiten der mehreren Referenz-Merkmale übereinstimmt. Beispielsweise kann ein Kurzschluss mit Auftreten eines Lichtbogens bestimmt werden, wenn das Merkmal des Messsignals mit einem ersten Merkmal des Referenzsignals bzw. einem ersten Referenz-Merkmal nicht übereinstimmt, welche kennzeichnend für einen normalen Betriebszustand ist, und mit einem zweiten Merkmal des Referenzsignals bzw. einem zweiten Referenz-Merkmal übereinstimmt, welches kennzeichnend für einen Kurzschluss mit Auftreten eines Lichtbogens, jedoch nicht kennzeichnend für einen Kurzschluss ohne Auftreten eines Lichtbogens ist.

Ein Übereinstimmen von Merkmalen kann bestimmt werden, wenn eine Abweichung zwischen den Merkmalen einen festgelegten Wert nicht überschreitet. Der festgelegte Wert kann ein absoluter oder ein relativer Wert, beispielsweise ein Prozentsatz sein. Ein NichtÜbereinstimmen von Merkmalen kann bestimmt werden, wenn eine Abweichung zwischen den Merkmalen den festgelegten Wert überschreitet.

Alternativ können mehrere Merkmale des Messsignals mit einem oder mehreren Merkmalen des Referenzsignals bzw. mit einem oder mehreren Referenz-Merkmalen verglichen werden, um einen Kurzschluss mit Auftreten eines Lichtbogens zu bestimmen. Hierbei gelten die obigen Ausführungen zum Vergleich eines Merkmals des Messsignals mit einem oder mehreren Merkmalen des Referenzsignals bzw. einem oder mehreren Referenz-Merkmalen entsprechend.

Für das Vergleichen des Messsignals mit dem Referenzsignal können aus dem Messsignal mehrere Merkmale extrahiert werden. Beispielsweise können die Merkmale Frequenzanteile umfassen, die mittels FFT, DFT, Wavelet und/oder digitale Filter extrahiert werden.

Aus den Merkmalen kann ein Merkmalsvektor bestimmt werden. Aus Merkmalen des Referenzsignals bzw. Referenzmerkmalen kann ein Referenzvektor bestimmt werden. Das Vergleichen des Messsignals mit dem Referenzsignal kann das Berechnen eines Differenzvektors aus dem Merkmalsvektor und dem Referenzvektor umfassen. In alternativen Ausgestaltungen kann ein Vergleich eines Einzelmerkmals erfolgen.

Das Vergleichen des Messsignals mit dem Referenzsignal kann eine Klassifikation des Messsignals umfassen. Beispielsweise kann der Vergleich des Messsignals mit dem Referenzsignal ausschließlich durch eine Klassifikation des Messsignals anhand eines oder mehrerer Referenzmerkmale erfolgen. Die Klassifikation des Messsignals kann mit Hilfe wenigstens eines Verfahrens aus der folgenden Gruppe erfolgen: Mustererkennung, künstliches neuronales Netz, Fuzzy-Logik, Maximalwertbestimmung, Minimalwertbestimmung, Deep Learning und maschinelles Lernen.

In einer beispielhaften Ausgestaltung wird das Messsignal mit dem Referenzsignal verglichen, indem Ähnlichkeiten zwischen dem Merkmalsvektor und wenigstens einem Referenzmerkmalsvektor gesucht werden. Beispielsweise kann der Merkmalsvektor von dem Referenzmerkmalsvektor subtrahiert werden. Anschließend kann eine absolute Distanz betrachtet werden. Anhand der absoluten Distanz kann bestimmt werden, ob das Messsignal dem Referenzsignal entspricht. Beispielsweise kann bestimmt werden, dass das Messsignal dem Referenzsignal entspricht, wenn die bestimmte absolute Distanz kleiner als eine vorbestimmte absolute Vergleichs-Distanz ist.

In alternativen Ausgestaltungen kann geprüft werden, ob einzelne Merkmale einen Maximaloder Minimalwert über- bzw. unterschreiten. Hierbei kann eine Klassifikation beispielsweise mittels eines Klassifikators mit einer Fuzzy-Logik stattfinden.

Alternativ oder zusätzlich kann ein Vergleich anhand einer Mustererkennung durchgeführt werden, zum Beispiel auf Basis eines künstlichen neuronalen Netzes. Hierbei kann das Netz mit Hilfe von Referenzsignalen trainiert werden. Dabei kann sich das Netz so konfigurieren, dass eine Bestimmung der relevanten Merkmale später durch das Netz selbst erfolgt.

Das Ergebnis einer Klassifikation kann eine Zuordnung des Messsignals zu einer von wenigstens zwei Klassen umfassen. Hierbei kann eine erste Klasse einen Zustand eines Kurzschlusses mit Auftreten eines Lichtbogens repräsentieren. Eine zweite Klasse kann einen Zustand ohne einen Kurzschluss repräsentieren. Alternativ können mehr als zwei Klassen vorgesehen sein, um einen differenzierten Vergleich zu ermöglichen.

Unter Verwendung des Ergebnisses des Vergleichs des Messsignals mit dem Referenzsignal kann eine Amplitude eines Kurzschlussstroms bestimmt werden. Der Kurzschlussstrom kann der Strom sein, der während eines Kurzschlusses mit Auftreten eines Lichtbogens auftritt. Der Kurzschlussstrom kann in dem elektrischen Leiter und/oder zwischen dem elektrischen Leiter und dessen Umgebung, beispielsweise einem weiteren elektrischen Leiter in der Umgebung des elektrischen Leiters, auftreten. Der Kurzschlussstrom kann mittels Vergleichen eines Strom-Merkmals des Messsignals mit einem Strom-Merkmal des Referenzsignals bzw. einem Strom-Referenz-Merkmal bestimmt werden. Alternativ kann ein Merkmal des Messsignals mit Hilfe einer mathematischen Abbildungsvorschrift in einen Strom umgesetzt werden. Die obigen Ausführungen zum Bestimmen des Kurzschlusses mit Auftreten eines Lichtbogens mittels Vergleichen des Merkmals des Messsignals mit dem Merkmal des Referenzsignals bzw. dem Referenz-Merkmal gelten für das Bestimmen des Kurzschlussstroms mittels Vergleichen eines Strom-Merkmals des Messsignals mit einem Strom-Merkmal des Referenzsignals bzw. einem Strom-Referenz-Merkmal entsprechend. Insbesondere können eine oder mehrere Strom-Merkmale des Messsignals mit einem oder mehreren Strom-Merkmalen des Referenzsignals bzw. einem oder mehreren Strom-Referenz-Merkmalen verglichen werden. Aufgrund des bestimmten Kurzschlussstroms kann eine Wirkung auf den elektrischen Leiter oder die Umgebung des elektrischen Leiters abgeschätzt werden.

Unter Verwendung des Ergebnisses des Vergleichs des Messsignals mit dem Referenzsignal kann ein Spannungsverlauf eines Kurzschlussstroms bestimmt werden. Die obigen Ausführungen zum Bestimmen eines Kurzschlussstroms unter Verwendung des Ergebnisses des Vergleichs des Messsignals mit dem Referenzsignal gelten für das Bestimmen des Spannungsverlaufs eines Kurzschlussstroms entsprechend. Insbesondere können eine oder mehrere Spannungs-Merkmale des Messsignals mit einem oder mehreren Spannungs-Merkmalen des Referenzsignals bzw. einem oder mehreren Spannungs-Referenz-Merkmalen verglichen werden. Aufgrund des bestimmten Spannungsverlaufs während des Kurzschlussstroms kann eine Wirkung auf den elektrischen Leiter oder die Umgebung des elektrischen Leiters abgeschätzt werden.

Unter Verwendung des Ergebnisses des Vergleichs des Messsignals mit dem Referenzsignal kann ein Betriebszustand des elektrischen Leiters bestimmt werden. Der Betriebszustand kann das Auftreten eines Kurzschlusses mit Auftreten eines Lichtbogens sein. Alternativ oder zusätzlich kann ein anderer Betriebszustand bestimmt werden, beispielsweise eine Stromstärke und/oder eine Spannungshöhe in dem elektrischen Leiter. Der Betriebszustand kann mittels Vergleichen eines Betriebszustands-Merkmals des Messsignals mit einem Betriebszustands-Merkmal des Referenzsignals bzw. einem Betriebszustands-Referenz-Merkmal bestimmt werden. Die obigen Ausführungen zum Bestimmen des Kurzschlusses mit Auftreten eines Lichtbogens mittels Vergleichen des Merkmals des Messsignals mit dem Merkmal des Referenzsignals bzw. dem Referenz-Merkmal gelten für das Bestimmen des Betriebszustands mittels Vergleichen eines Betriebszustands-Merkmals des Messsignals mit einem Betriebszustands-Merkmal des Referenzsignals bzw. einem Betriebszustands-Referenz-Merkmal entsprechend. Insbesondere können eine oder mehrere Betriebszustands-Merkmale des Messsignals mit einem oder mehreren Betriebszustands-Merkmalen des Referenzsignals bzw. einem oder mehreren Betriebszustands-Referenz-Merkmalen verglichen werden. Es kann eine regelmäßige Bestimmung des Betriebszustandes erfolgen, beispielsweise in vorbestimmten Intervallen. Mit dem Bestimmen eines Betriebszustands des elektrischen Leiters kann ein Monitoring des elektrischen Leiters realisiert sein, beispielsweise ein (quasi-)kontinuierliches Monitoring während des Betriebs.

In Reaktion auf das Bestimmen eines Kurzschlusses mit Auftreten eines Lichtbogens kann ein elektrisches Betriebsmittel aktiviert werden. Das elektrische Betriebsmittel kann ein Betriebsmittel sein, welches die Auswirkungen des Kurzschlussstroms beeinflusst und/oder begrenzt. Beispielsweise kann das Betriebsmittel Strombahnen kurzschließen, so dass der Kurzschluss mit Auftreten eines Betriebsmittels an dem elektrischen Leiter beseitigt wird. Alternativ oder zusätzlich kann das Betriebsmittel den Kurzschlussstrom zu einem anderen elektrischen Leiter kommutieren, indem die den Kurzschlussstrom führende Strombahn aufgesprengt wird und parallel dazu eine weitere Strombahn mit einem den Kurzschlussstrom ausschaltenden weiteren Betriebsmittel genutzt wird. Zusätzlich oder als weitere Alternative kann eine mit dem elektrischen Leiter verbundene Spannungsquelle durch das Betriebsmittel abgeschaltet werden. Die Aktivierung des elektrischen Betriebsmittels kann in Abhängigkeit von einer abgeschätzten Wirkung des Kurzschlussstroms erfolgen.

Allgemein kann in Reaktion auf das Bestimmen eines Kurzschlusses mit Auftreten eines Lichtbogens ein Potentialunterschied, aufgrund dessen der Lichtbogen voraussichtlich entstehen wird oder entstanden ist, überbrückt bzw. ausgeglichen werden.

Der elektrische Leiter kann eine Niederspannung, eine Hochspannung, eine Höchstspannung oder eine Ultra-Höchstspannung führen. Alternativ kann der elektrische Leiter eingerichtet sein, elektrische Spannungen unterschiedlicher Höhe zu führen. Hochspannungen können elektrische Spannungen über 1 kV sein. Insbesondere kann der elektrische Leiter Spannungen 3 kV, 6 kV, 10 kV, 15 kV, 20 kV, 30 kV, 60 kW, 110 kV, 220 kV, 380 kV, 500 kV, 700 kV oder 1150 kV führen. Es kann auch vorgesehen sein, dass der elektrische Leiter Niederspannung bis höchstens 1 kV führt.

Mit dem Verfahren kann ein besonders schnelles Bestimmen eines Kurzschlusses mit Auftreten eines Lichtbogens an einem elektrischen Leiter ermöglicht sein. Beispielsweise kann es ermöglicht sein, einen Kurzschluss mit Auftreten eines Lichtbogens innerhalb von deutlich weniger als 1 ms, zum Beispiel innerhalb von 0,7 ms, ab dem Auftreten des Kurzschlusses zu bestimmen. Wenn in Reaktion auf das Bestimmen eines Kurzschlusses mit Auftreten eines Lichtbogens ein elektrisches Betriebsmittel aktiviert wird, kann es ermöglicht sein, das elektrische Betriebsmittel besonders schnell zu aktivieren, beispielsweise innerhalb von deutlich weniger als 1 ms, zum Beispiel innerhalb von 0,7 ms, ab dem Auftreten des Kurzschlusses.

Das Messsignal kann sowohl Vibrationssignale als auch Schallsignale umfassen. Die Schallsignale können wenigstens eine Art Schallsignale aus der Gruppe Infraschallsignale, Hörschallsignale und Ultraschallsignale umfassen. Schallsignale im Sinne der Offenbarung umfassen Druck- und Dichteschwankungen in einem Medium. Dabei kann das Medium sowohl ein Körper sein (Körperschall) als auch Luft (Luftschall).

Falls das Messsignal mithilfe von mehreren Sensoren erfasst wird, können insbesondere ein Infraschall-Frequenzband und ein Ultraschall-Frequenzband mittels eines Vibrationssensors beziehungsweise eines Ultraschallsensors parallel erfasst und kombiniert verarbeitet werden.

Das Verarbeiten des Messsignals mittels der Auswerteeinrichtung kann eine Analog-DigitalWandlung des Messsignals in ein digitales Messsignal umfassen. Das Messsignal und/oder die ein oder mehrere Merkmale des Messsignals und/oder des Referenzsignals und die ein oder mehreren Merkmale des Referenzsignals bzw. die ein oder mehreren ReferenzMerkmale können digitale Messsignale und/oder Merkmale digitaler Messsignale sein.

Wenn das Messsignal mithilfe von mehreren Sensoren erfasst wird, können für die Analog-Digital-Wandlung ein Analog-Digital-Wandler im Multiplexverfahren oder mehrere Analog-Digital-Wandler im Parallelverfahren zum Einsatz kommen. Das jeweilige Messsignal verschiedener Sensoren kann zueinander in Beziehung gesetzt werden.

Es kann vorgesehen sein, dass die Sensoren Messsignale in verschiedenen Frequenzbändern erfassen. Die Frequenzbänder können sich überschneiden oder voneinander getrennt sein. Es kann des Weiteren vorgesehen sein, die Frequenzbänder unterschiedlicher Sensoren miteinander zu kombinieren, um die erfassbare Frequenzbandbreite zu erhöhen.

Es kann vorgesehen sein, dass mindestens ein Messsignal digital ohne Analog-DigitalWandlung an die Auswerteeinrichtung gesendet wird.

Das Messsignal kann beim Verarbeiten vorverarbeitet werden, wobei hierbei beispielsweise für das Messsignal das Signal-Rausch-Verhältnis vergrößert werden kann. Die Vorverarbeitung kann digital und/oder analog erfolgen. Analoge Verfahren zur Vorverarbeitung sind zum Beispiel eine Verstärkung und Filter wie Tiefpass-, Hochpass-, Bandpass- oder Anti-Aliasing-Filter. Digitale Verfahren zur Vorverarbeitung sind zum Beispiel Filter wie Kerbfilter (notch filter) sowie Wavelet-Analyse, diskrete Fourier-Transformation, Fast-Fourier-Transformation (FFT) und Short-Time-Fourier-Transformation. Werden mehrere Sensoren verwendet, kann auf jedes der Sensorsignale jeweils keines, eines oder mehrere der Verfahren angewendet werden. Das Messsignal kann mittels eines Anti-Aliasing-Filters vorverarbeitet werden.

Werden mehrere Sensoren verwendet, kann des Weiteren das Signal-Rausch-Verhältnis vergrößert werden, indem die Sensorsignale verschiedener Sensoren miteinander in Beziehung gesetzt und/oder gemittelt werden. Dies kann im Rahmen einer kanalübergreifenden digitalen Signalvorverarbeitung erfolgen.

Das Vergleichen des Messsignals mit dem Referenzsignal kann eine Klassifikation des Messsignals mittels mindestens eines Klassifikationsverfahrens umfassen. Das Klassifikationsverfahren kann ein maschinelles Klassifikationsverfahren sein. Als Klassifikationsverfahren können beispielsweise künstliche neuronale Netze, Fuzzy-Logiken oder Entscheidungsbäume eingesetzt werden. Die Klassifikation des Messsignals kann einstufig oder mehrstufig erfolgen.

Die Klassifikation kann erfolgen, indem mindestens ein Merkmal des Messsignals analysiert wird mittels Zuordnung vergleichbarer Merkmale von Messsignalen zu bestimmten Ursachen und/oder Gruppierungen vergleichbarer Messsignale.

Die Bestimmung des Kurzschlusses mit Auftreten eines Lichtbogens kann in Hardware und/oder Software umgesetzt sein. Es können ein oder mehrere Prozessoren der Gruppe CPU, Mikroprozessor, eingebettetes System, digitaler Signalprozessor, GPU eingesetzt werden. Es können ein oder mehrere programmierbare Logikbausteine aus der Gruppe Complex Programmable Logic Device (CPLD), Field Programmable Gate Array (FPGA), Gate Array und Standard Cell eingesetzt werden. Es kann ein Full-Custom Chip zum Einsatz kommen.

Es kann vorgesehen sein, ein Ergebnis an eine Ausgabeeinrichtung weiterzuleiten, Die Ausgabeeinrichtung kann lokal sein oder über ein Netzwerk mit der Auswerteeinrichtung verbunden. Das Ergebnis kann den bestimmten Kurzschluss und/oder die Analyse eines mit dem bestimmten Kurzschluss zusammenhängenden Betriebszustands umfassen. Die Weiterleitung des Ergebnisses kann durchgängig erfolgen. Es kann eine durchgängige Überwachung des Ergebnisses durch Wartungspersonal vorgesehen sein. Es kann auch vorgesehen sein, die Ergebnisse aus mehreren Anordnungen in der Ausgabeeinrichtung zusammenzuführen. Die Weiterleitung kann zum Beispiel über ein Netzwerk erfolgen. Auf diese Weise können geeignete Maßnahmen durch das Wartungspersonal ergriffen werden. Das Ergebnis kann auf einem physikalischen Datenträger gespeichert werden.

Die Ausgabeeinrichtung kann ein oder mehrere Ausgabegeräte umfassen. Dies kann beispielsweise ein Display, ein oder mehrere LEDs oder ein oder mehrere Lautsprecher sein. Es kann vorgesehen sein, das Ergebnis für die Ausgabe aufzubereiten. Das Ergebnis kann in mindestens einer der folgenden Formen ausgegeben werden: tabellarische Form, Graphen, Diagramme, Auflistung von Wahrscheinlichkeiten und Signaltöne. Es kann eine binäre oder ternäre Darstellung des Ergebnisses erfolgen. Die Darstellung des Ergebnisses kann farblich gestaltet sein, beispielsweise rot/grün (binär) oder als Ampel (ternär).

Die Auswerteeinrichtung kann in unmittelbarer Nähe und/oder entfernt von dem elektrischen Leiter angeordnet sein.

Es kann mittels der Auswerteeinrichtung ein normaler Betriebszustand oder ein Nicht-Kurzschluss-Zustand bestimmt werden, wenn kein Kurzschluss mit Auftreten eines Lichtbogens bestimmt wird.

In Verbindung mit der Anordnung können die vorangehend im Zusammenhang mit dem Verfahren zum Bestimmen eines Kurzschlusses mit Auftreten eines Lichtbogens an einem elektrischen Leiter beschriebenen Ausgestaltungen entsprechend vorgesehen sein.

Beschreibung von Ausführurigsbeispielen

Im Folgenden werden weitere Ausführungsbeispiele unter Bezugnahme auf Figuren einer Zeichnung näher erläutert. Hierbei zeigen:

Fig. 1    eine schematische Darstellung einer Anordnung zum Bestimmen eines Kurzschlusses mit Auftreten eines Lichtbogens;

Fig. 2    eine schematische Darstellung eines faseroptischen Sensors zur Erfassung von Vibrationssignalen und/oder Schallsignalen;

Fig. 3    eine graphische Darstellung der Verläufe der dreiphasigen Ströme und Spannungen bei einer Lichtbogenzündung;

Fig. 4    eine schematische Darstellung eines Spektrogramms eines Messergebnisses an einem faseroptisch-akustischen Sensor beim Zuschalten eines Leistungsschalters auf einen Kurzschlussstrom;

Fig. 5    eine schematische Darstellung eines Spektrogramms eines Messergebnisses an einem faseroptisch-akustischen Sensor bei Einschaltung eines Leistungsschalters im Schaltfeld ohne Stromfluss;

Fig. 6    eine schematische Darstellung eines Ergebnisses einer grafischen Subtraktion der Spektrogramme aus den Figuren 4 und 5;

Fig. 7    eine schematische Darstellung eines Spektrogramms eines Messergebnisses an einem faseroptisch-akustischen Sensor beim Zünden eines Lichtbogens am Ende eines Energiekabels; und

Fig. 8    einen Ausschnitt aus dem zeitlichen Verlauf eines Kurzschlussstromes in einer Phase eines dreiphasigen Netzsystems.

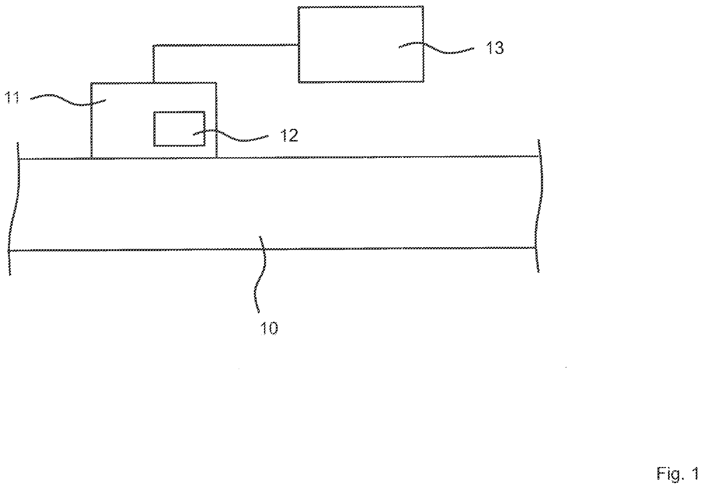

Fig. 1 zeigt eine Anordnung zum Bestimmen eines Kurzschlusses mit Auftreten eines Lichtbogens an einem elektrischen Leiter 10. Auf dem elektrischen Leiter 10 ist eine Sensoreinrichtung 11 angeordnet. Die Sensoreinrichtung 11 weist einen Sensor 12 auf. In dem gezeigten Ausführungsbeispiel handelt es sich bei dem Sensor 12 um einen faseroptischen Sensor. Mittels des Sensors 12 wird ein Messsignal erfasst, welches eine Vibration des elektrischen Leiters 10 angibt.

Eine Auswerteeinrichtung 13 ist mit der Sensoreinrichtung 11 verbunden Die Auswerteeinrichtung empfängt das mittels des Sensors 12 ermittelte Messsignal von der Sensoreinrichtung 11 und bestimmt aus den Sensorsignalen Merkmale des Messsignals. In einer beispielhaften Ausführung handelt es sich bei den Merkmalen um die spektralen Anteile des Messsignals. Die spektralen Anteilen können beispielsweise um verschiedene Frequenzbereiche angeben, für welche das Messsignal eine Mindest-Amplitude überschreitet, wobei die Merkmale des Messsignals diese Frequenzbereiche angeben. Hierzu wird das Messsignal durch Fourier-Transformation in seine Frequenzanteile zerlegt. Anschließend werden einzelne Frequenzlinien (Bins) betrachtet. In einem weiteren Beispiel werden einzelne benachbarte aber auch einzelne nicht zusammenhängende Frequenzbereiche zusammengefasst. Hierbei kann insbesondere der zeitliche Verlauf der einzelnen Frequenzbereiche interessieren. So kann der 100Hz-Anteil im Spektrum über die Zeit eine immer kleiner werdende Amplitude aufweisen.

In der Auswerteeinrichtung 13 werden die Merkmale des Messsignals mit ReferenzMerkmalen verglichen. Hierzu werden die Merkmale einer Merkmalsklasse zugeordnet. Diese Zuordnung der Merkmale zu einer Merkmalsklasse erfolgt durch einen Klassifikator, der durch wenigstens eines der folgenden Verfahren realisiert ist: künstliches neuronales Netz, Fuzzy-Logik, Distanzbestimmung zu den Referenzmerkmalen, Schwellwertbestimmung ausgewählter Merkmale. Wenigstens eine der Merkmalsklassen repräsentiert einen Zustand eines Kurzschlusses mit Auftreten eines Lichtbogens. Wenn die Merkmale des Messsignals durch den Klassifikator einer Merkmalsklasse zuordnet werden, die einen Zustand eines Kurzschlusses mit Auftreten eines Lichtbogens repräsentiert, wird mittels der Auswerteeinrichtung 13 ein Kurzschluss mit Auftreten eines Lichtbogens bestimmt.

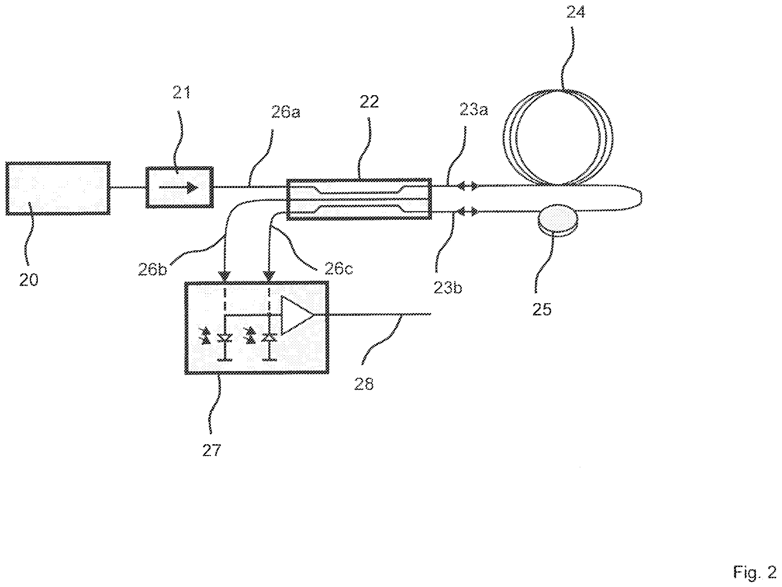

Fig. 2 zeigt eine schematische Darstellung eines faseroptischen Sensors zur Erfassung von Vibrationssignalen und/oder Schallsignalen mit Hilfe eines Sagnac-Interferometers. Selbstverständlich ist es möglich, andere Sensorprinzipien zu nutzen, wie zum Beispiel eine Fabry-Perot-Konfiguration, bei der zwei Faserenden über einen kleinen Zwischenraum gekoppelt werden, oder ein Mach-Zehnder-Interferometer, wobei gegebenenfalls auftretende Phasensprünge zu berücksichtigen sind.

In der Darstellung der Fig. 2 erfolgt eine Erfassung von Vibrationssignalen und/oder Schallsignalen über eine Messung von Längenänderungen in einer faseroptischen Spule. Ein Laser oder eine Superlumineszenzdiode (SLED) 20 erzeugt kohärentes Licht, das durch einen optischen Isolator 21 geführt wird (insbesondere zur Vermeidung unerwünschter Rückreflexionen) und mit Hilfe eines optischen $3 \times 3$-Kopplers 22 dreigeteilt wird. Zwei dieser drei Lichtwellen 23a, 23b durchlaufen anschließend einmal im Uhrzeigersinn und einmal im Gegenuhrzeigersinn die Verzögerungsspule 24 und die Faserspule 25. Der Weg durch die Verzögerungsspule 24 ist deutlich länger als der durch die Faserspule 25. Deshalb passiert zuerst der Lichtstrahl über 23b die Faserspule und etwas verzögert der Lichtstrahl über 23a. In dieser kurzen Differenzzeit ändert die Faserspule infolge des Einwirkens von Schall- oder Vibrationssignalen ihre Ausdehnung. Dies führt zu einer Phasenverschiebung der beiden Lichtwellen zueinander.

Der 3x3-Koppler 22 wird nun erneut in umgekehrter Richtung durchlaufen. Dabei werden die beiden Lichtwellen zur Interferenz gebracht. An der linken Seite des 3x3-Kopplers 22 werden drei Interferenzsignale 26a, 26b, 26c ausgegeben. Aufgrund der Arbeitsweise des Kopplers sind die drei Signale vom Verlauf her identisch, weisen aber eine Phasenverschiebung von $2\pi/3$ (120°) auf. Die Interferenzsignale 26b und 26c werden nun auf einen Balanced Detector 27 geführt, in dem die optischen Signale in elektrische Signale gewandelt und voneinander subtrahiert werden. Letzteres ist erforderlich, da die Interferenzsignale 26b, 26c sinusförmig sind und Winkeländerungen eines Sinussignals kaum Änderungen des Ausgangssignals verursachen, wenn der Phasenwinkel nahe bei 90° liegt. Die Subtraktion bewirkt folglich eine Optimierung des Arbeitspunktes.

Das Sagnac-Interferometer hat den Vorteil, robust gegen Temperaturschwankungen zu sein. Außerdem lässt sich das Frequenzverhalten über die Verzögerungsspule 24 einstellen. Das Sagnac-Interferometer lässt sich daher zur Messung niederfrequenter Eingangssignale verwendet werden.

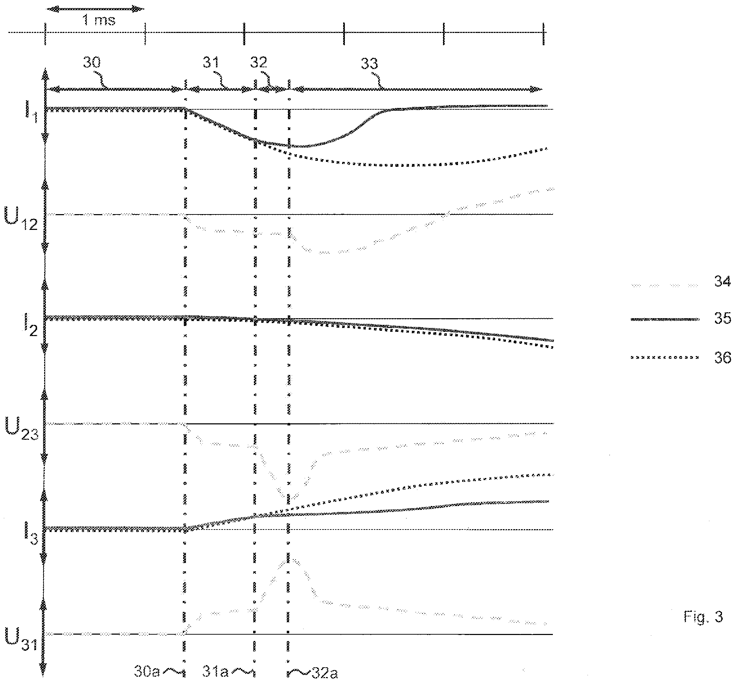

Die Fig. 3 zeigt in verschiedenen Zeitabschnitten (30 bis 33) die dreiphasigen Ströme $I_1$, $I_2$, $I_3$ und Spannungen $U_1$, $U_2$, $U_3$, 34 einer Lichtbogenzündung gemäß einem Entwurf der internationalen Norm IEC 60947-9-2 ED1 (Low-voltage switchgear and controlgear - Active arcfault mitigation systems - Part 9-2: Optical-based internal arc-detection and mitigation devices). Zu den Strömen $I_1$, $I_2$, $I_3$ sind jeweils der Kurzschlussstrom mit Lichtbogenerscheinung 35 sowie der Kurschlussstrom ohne Lichtbogenerscheinung 36 (prospektiver Kurzschlussstrom) dargestellt. Die Spannungen 34 beziehen sich auf Spannungen bei Lichtbogenerscheinung. Somit lassen sich Verläufe der Spannungen 34 auch einem Lichtbogenereignis zuordnen.

Zeitabschnitt A (30) - Vor-Testphase: Der Versuch ist vorbereitet und eine Kurzschlusseinschaltung kann erfolgen. Dieser Zeitabschnitt dauert bis zum Zeitpunkt 30a. Ab dem Zeitpunkt 30a wird ein Kurzschluss eingeleitet. Dazu wurde mit Hilfe eines Drahtes eine Kurzschlussbrücke hergestellt.

Zeitabschnitt B (31) vom Zeitpunkt 30a bis zum Zeitpunkt 31a - Pre-arcing: In der Zeit vor dem Entstehen eines Lichtbogens sind die Ströme 35, 36 über einem Zünddraht nahezu sinusförmig. Der Zünddraht bildet einen dreiphasigen Kurzschluss und dient als Auslöser für einen Lichtbogen, da dieser bedingt durch den sehr hohen Kurzschlussstrom explosionsartig wegschmilzt. Der in der Schmelzphase des Drahtes fließende Strom ist sinusförmig, eine Lichtemission findet zunächst nicht statt. Die Ströme 35, 36 steigen zu diesem Zeitpunkt bereits sehr stark an. Es tritt eine hohe zeitliche Änderung der Ströme 35, 36 auf. Die Spannungen 34 sind nicht mehr sinusförmig, allerdings unterscheiden sie sich deutlich von Null Volt. Zum Zeitpunkt 31a ist der den Kurzschluss bildende Draht weggeschmolzen und es bildet sich ein Lichtbogen aus.

Zeitabschnitt C (32) vom Zeitpunkt 31a bis zum Zeitpunkt 32a - First ignition of the arc: Erst in dem dritten Zeitabschnitt 32 ist eine optische Detektion eines Lichtbogens möglich. Die nun fließenden Ströme 35 sind nicht mehr sinusförmig, sondern überlagert durch hochfrequente Stromanteile. Der Spannungsabfall über dem Zünddraht setzt sich zusammen aus der Anoden- und Kathodenfallspannung sowie dem induktiven Spannungsabfall. Es entsteht gegenüber dem Zeitabschnitt 31 eine Zunahme der Phasenspannung 34, in der der zunächst Lichtbogen wirkt. Die Zunahme der Lichtbogenspannung dauert bis zum Zeitpunkt 32a. Ab Zeitpunkt 32a brennt der Lichtbogen kontinuierlich.

Zeitabschnitt D (33) - Continous arcing: Der vierte Zeitabschnitt 33 geht einher mit einer dauerhaften kontinuierlichen Lichtbogenerscheinung. Der Spannungsabfall ändert sich gegenüber dem vorangegangenen Zeitabschnitt 32 und geht auf die Lichtbogenbrennspannung über. Der Lichtbogen ist nunmehr quasistationär. Der fließende Strom ist mit einem hohen Oberwellengehalt angereichert. Der prospektive Kurzschlussstrom 36 unterscheidet sich in der Höhe deutlich von einem Kurzschlussstrom mit dem Auftreten eines Lichtbogens. Mit dem Auftreten eines Lichtbogens entsteht eine zusätzliche Lichtbogenbrennspannung, die einen reduzierten Kurzschlussstrom 35 gegenüber dem Kurzschlussstrom 36 ohne Lichtbogeneffekt entstehen lässt.

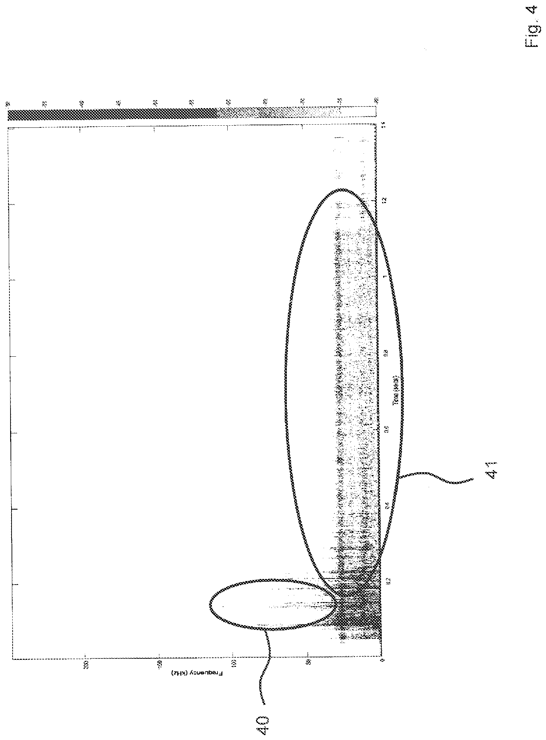

Im Folgenden werden unter Bezug auf die Figuren 4 bis 8 ein Verfahren zum Bestimmen eines Kurzschlusses mit Auftreten eines Lichtbogens sowie Referenzmessungen und Berechnungen für das Verfahren beschrieben. Die Figuren 4 bis 7 zeigen Spektrogramme, in denen der zeitliche Verlauf der Intensitätsverteilung von Frequenzanteilen dargestellt ist. Hierbei sind auf der X-Achse die Zeit und auf der Y-Achse die Frequenz angegeben. Die Intensität einer Frequenz zu einer bestimmten Zeit ist mittels Helligkeit abgebildet, wobei eine dunkle Darstellung einer Frequenz einer hohen Intensität entspricht und eine helle Darstellung einer niedrigen Intensität entspricht.

Die Fig. 4 zeigt ein Spektrogramm eines Messergebnisses an einem faseroptisch-akustischen Sensor beim Zuschalten eines Leistungsschalters auf einen Kurzschlussstrom von 10 kA. Im ersten Augenblick sind dort ab Zeitpunkt t = 230 ms die durch den Leistungsschalter angeregten Frequenzen 40 zu erkennen. Sie werden durch die Bewegungen innerhalb des Leistungsschalters und der Stromschiene hervorgerufen. Zum Zeitpunkt t = 270 ms sind die Schalterpole geschlossen und der Kurzschlussstrom beginnt zu fließen. Mit dem Kurzschlussstrom kommt es zu hohen Amplituden verschiedener spektraler Anteile. Im weiteren Verlauf 41 klingen dann die Amplituden der spektralen Anteile ab. Dieser Vorgang dauert bis zum Zeitpunkt t = 1,7 s, also erkennbar länger als der Kurzschlussstrom mit einer Zeitdauer von t = 1,01 s fließt. Damit sind mechanische Anregungen innerhalb der Leistungsschalter-Schaltanlagenkombination erkennbar. Die Analyse dieses Spektrums erlaubt Aussagen zum mechanischen und funktionalen Zustand der Schaltanlagen-Leistungsschalterkombination in der Art, ob sich Veränderungen in der Struktur und in den funktionalen zeitlichen Abläufen ergeben haben (Ausschaltvorgang).

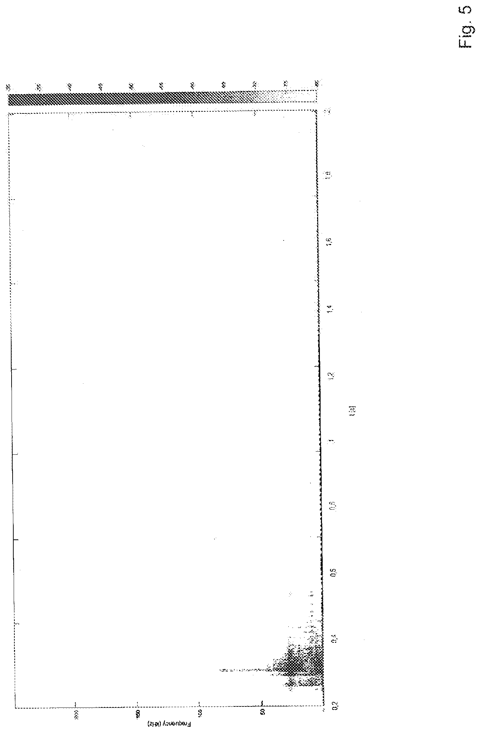

Die Fig. 5 zeigt das Spektrogramm bei Einschaltung eines Leistungsschalters im Schaltfeld ohne Stromfluss. Es fehlen in der Darstellung die durch den zusätzlichen Kurzschlussstromfluss verursachten Spektralanteile.

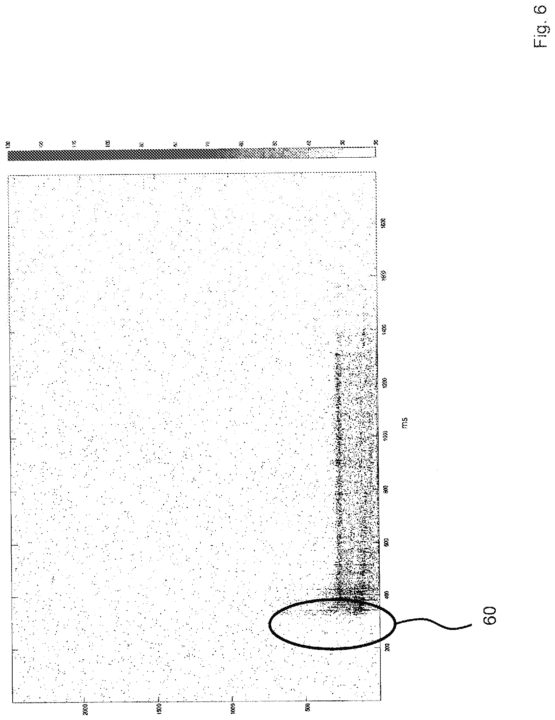

Subtrahiert man grafisch vom Spektrogramm in der Fig. 4 die in der Fig. 5 erkennbaren Frequenzanteile, die durch den Leistungsschalter während des Einschaltprozesses verursacht werden 60, so erhält man, wie in der Fig. 6 dargestellt, die durch den Kurzschlussstrom in der Schaltanlage verursachte Anregung als Spektrogramm. Aus diesem Spektrogramm sind nun der Anregezeitpunkt, die Stromflussdauer sowie die Amplituden der spektralen Anteile erkennbar. Eine Variation der Stromhöhe geht dabei einher mit der Höhe der Amplituden der spektralen Anteile.

Die in der Fig. 4 und in der Fig. 5 gezeigten Spektren wurden bei einem über eine geschlossene Strombrücke in Form eines massiven Kupferleiters geführten Kurzschlussstrom ermittelt.

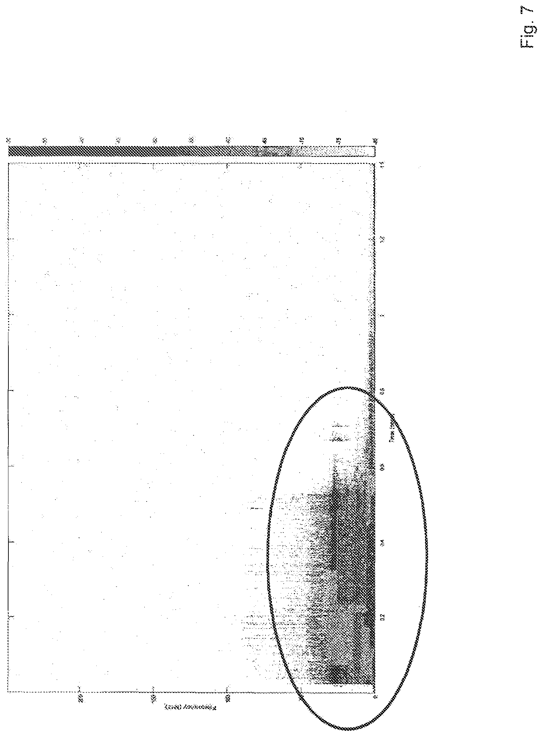

Die Fig. 7 zeigt ein Spektrogramm beim Zünden eines Lichtbogens am Ende eines Energiekabels. Es ist eine deutlich andere Frequenzverteilung im Vergleich zu einer Kurzschlussstromübertragung ohne Lichtbogeneffekt entsprechend der Fig. 4 erkennbar.

Mit Hilfe von frequenzanalytischen Verfahren wie der Fourieranalyse, Kurzzeit-Fourieranalyse, Wavelet-Analyse usw. kann somit eine Detektion von lichtbogenbehafteten Kurzschlüssen durch Einsatz von faseroptischen Sensoren ermöglicht sein. Es kann eine Erfassung einer Stromwirkung ermöglicht sein, mittels derer Zustände danach unterscheidbar sind, ob ein Lichtbogen auftritt oder nur ein Kurzschlussstrom fließt, der zu einer mechanischen Anregung führt.

Darüber hinaus kann es ermöglicht sein, die Stromamplitude anhand der Amplituden der Spektralanteile abzuschätzen und deren Wirkung zu bewerten. Ebenso kann es ermöglicht sein, durch eine Veränderung der spektralen Zusammensetzung des Messsignals auf den Zustand der Schaltanlage, der angeschlossenen Leitungen und Kabel sowie der Strombahnen zu schließen. Damit kann ein Zustandsmonitoring der Betriebsmittel ermöglicht sein.

Zugleich kann es ermöglicht sein, deutlich schneller und sicherer das Auftreten eines Lichtbogens zu erkennen als mit optischen Verfahren welche einen auftretenden Lichtbogen optisch erfassen, da die Zeit bis zum Aufschmelzen einer Drahtverbindung hier nicht relevant ist.

Während dem Aufschmelzen des Zünddrahtes kommt es bereits zu einem deutlichen Stromanstieg, der signifikant über dem Betriebsstrom eines Stromkreises liegen kann. Werden dieser Stromanstieg und die damit verbundenen mechanischen Anregungen mit Hilfe eines faseroptisch-akustischen Sensors aufgenommen und dessen Messdaten schnell genug ausgewertet, kann es ermöglicht sein, bereits vor dem Aufschmelzen des Zünddrahtes, Schutzmaßnahmen einzuleiten. Beispielsweise kann das Kommutieren des ansteigenden Kurzschlussstromes eingeleitet werden, um die Effekte des Lichtbogens in ihrer Wirkung zu reduzieren.

Das Erfassen der mechanischen Anregungen mit einem hochempfindlichen faseroptischen Sensor kann deutlich sensitiver und schneller gegenüber spektralen optischen Lichtbogenerfassungen sein. Es kann ermöglicht sein, bereits die mechanische Anregung durch den Stromanstieg in Zeitabschnitt B (31) gemäß der Fig. 3 zu erfassen. In diesem Zeitabschnitt B (31) existiert noch kein durch das Zünden eines Lichtbogens ausgelöster Lichtblitz.

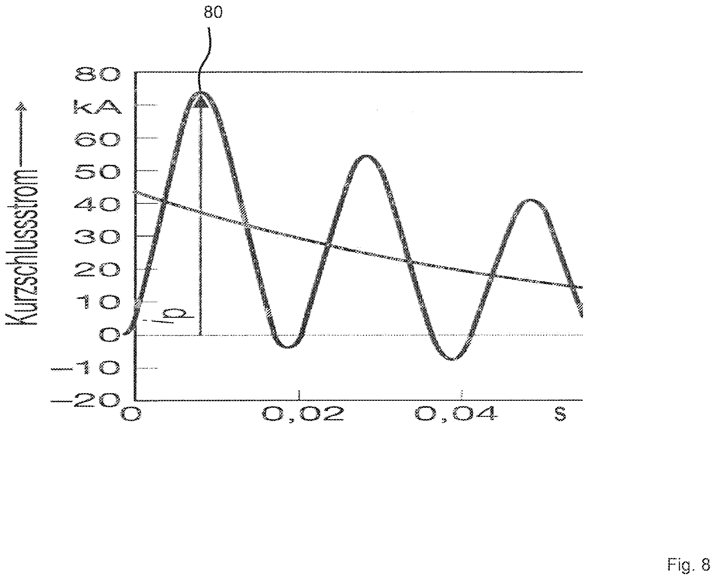

Die Fig. 8 zeigt einen Ausschnitt aus dem zeitlichen Verlauf des Kurzschlussstromes in einer Phase eines dreiphasigen Netzsystems. Gemäß der Darstellung in der Fig. 8 entsteht innerhalb von maximal 10 ms die größte Stromamplitude 80, der sogenannte Stoßstrom $i_p$, der die höchste mechanische Belastung für die Kurzschlussstrombahn sowie die darin befindlichen elektrischen Betriebsmittel darstellen kann. Folglich stehen hier maximal 10 ms zur Verfügung, um eine Schadenswirkung durch eine mechanische Belastung mittels geeigneter Maßnahmen nennenswert zu beeinflussen. Dem maximalen Stoßstrom $i_p$ geht eine hohe Stromanstiegsgeschwindigkeit di/dt voraus.

Um die Folgen eines Lichtbogens sowie die hohen mechanischen Belastungen für die umgebenden Betriebsmittel in erheblichem Umfang zu vermeiden, kann in kürzester Zeit (bevorzugt innerhalb von 0,7 ms, weiter bevorzugt innerhalb von deutlich weniger als 0,7 ms) eine Erkennung und Abschaltmaßnahme eingeleitet werden.

Gemäß der Fig. 3 kommt es erst zum Zeitpunkt t= 0,7 ms zum Aufschmelzen des Zünddrahtes. Allerdings steigt der Kurzschlussstrom bereits am Ende des Zeitabschnitt B (31) stark an, d.h. bereits vor dem Aufschmelzen des Kurzschlussdrahtes. Es kommt spätestens nach 10 ms zu einem Stoßstrom $i_p$ sowie zu einem starken Stromanstieg mit einem hohen di/dt. Dies kann zu einer entsprechenden mechanischen Anregung führen. Der Stromanstieg kann durch die ohmsch-induktiven Impedanzen der Kurzschlussstrombahn sowie dem auftretenden Lichtbogen begrenzt sein.

Im Vergleich dazu kann die mechanische Anregung aufgrund des stark ansteigenden Stromes ohne Zeitverzug und somit sofort eintreten. Mit dem Verfahren zum Bestimmen eines Kurzschlusses mit Auftreten eines Lichtbogens kann somit eine Erkennung von Lichtbogeneffekten ermöglicht sein, die deutlich schneller als bereits vorhandene Verfahren und gleichzeitig weniger empfindlich gegenüber äußeren Beeinflussungen ist, beispielsweise durch Licht und/oder andere elektromagnetische Wellen. Auch kann ein visueller Kontakt zwischen einem lichtbogensensitiven Sensor und der Entstehungsstelle des Lichtbogens entfallen.

In einem Ausführungsbeispiel stellt sich in einem fehlerfreien Betriebszustand eines elektrischen Leiters, der eine Wechselspannung mit einer Frequenz von 50 Hz führt, ein 100 Hz-Anregesignal ein, mittels dessen es ermöglicht sein kann, den Betriebsstrom leicht von nichtsinusförmigen Strömen und Anregungen zu unterschieden. Ein entsprechender mathematischer Zusammenhang ist nachfolgend beschrieben.

Die Kraft zwischen zwei stromdurchflossenen Leitern lässt sich wie folgt beschreiben:

$$F_{(t)} = \frac{\mu_0 \cdot I_1(t) \cdot I_2(t) \cdot \ell}{2 \cdot \pi \cdot a}.$$

Hierbei sind

$\mu_0$     die magnetische Feldkonstante,
$\ell$     die Länge der parallel laufenden Strombahnen,
a     der Abstand zwischen den Strombahnen,
$I_1(t)$     der zeitliche Verlauf des Stroms im ersten Leiter,
$I_2(t)$     der zeitliche Verlauf des Stroms im zweiten Leiter.

Für die beiden Ströme $I_1(t)$ und $I_2(t)$ wird ein sinusförmiger Verlauf angenommen, so dass sich die Ströme wie folgt beschreiben lassen:

$$I_1(t) = I_1 \cdot \sin(2\pi f t)$$

und

$$I_2(t) = I_2 \cdot \sin(2\pi f t).$$

Im Kurzschlussfall gilt $I_1(t) = I_2(t)$. Damit ergibt sich

$$F_{(t)} = \frac{\mu_0 \cdot I_1^2(t) \cdot \ell}{2 \cdot \pi \cdot a}.$$

Werden die konstanten Größen zusammengefasst, vereinfacht sich diese Formel zu

$$F_{(t)} = K \cdot I_1^2(t)$$

oder zu

$$F_{(t)} = K \cdot I_1^2 \cdot \left(\frac{1}{2} + \cos 2 \cdot (2\pi f t)\right).$$

Der auftretende zeitliche Verlauf der sich ergebenden Kraft hängt von einer zusammengefassten Konstante sowie dem Quadrat des Kurzschlussstromes ab. Dabei treten ein konstanter Kraftwert sowie ein mit doppelter Frequenz schwingender Kraftverlauf auf.

Vor dem Kurzschlusseintritt gilt für den Kraftverlauf dann:

$$F_{(t)_{vor}} = K \cdot I_1^2(t)_{vor}$$

oder

$$F_{(t)_{vor}} = K \cdot I_{1vor}^2 \cdot \left(\frac{1}{2} + \cos 2 \cdot (2\pi f t)\right).$$

$I_1(t)_{vor}$ ist der Betriebsstrom im ungestörten Betriebsfall.

Während des Kurzschlusses gilt für den Kraftverlauf:

$$F_{(t)_{während}} = K \cdot I_1^2(t)_{während}$$

oder

$$F_{(t)_{während}} = K \cdot I_{1während}^2 \cdot \left(\frac{1}{2} + \cos 2 \cdot (2\pi f t)\right).$$

Die Änderung des zeitlichen Kraftverlaufs dF/dt lässt sich mit der zeitlichen Ableitung des Kraftverlaufs beschreiben:

$$\frac{dF(t)}{dt} = -K \cdot I^2_{1\text{während}} \cdot (2 \cdot 2\pi f \sin 2 \cdot (2\pi f t)) \,.$$

Bei der Analyse der Gleichungen ist zu beachten, dass die Ströme $I_1(t)_{vor}$ und $I_1(t)_{während}$ sich in Gleichspannungs-Netzen um einen Faktor $K \geqq 1,2$ und in Wechselspannungs-Netzen um einen Faktor $K \geqq 1,8$ unterscheiden. Hierdurch kann es ermöglicht sein, eine Anregung durch einen Kurzschlussstrom von einem normalen Betriebsstrom zu unterscheiden. Es kann somit eine sichere Detektion eines Kurzschlusses mit Auftreten eines Lichtbogens aufgrund der unterschiedlichen Stromhöhen und Stromarten, Gleichspannung oder Wechselspannung, gewährleistet sein.

Es kann vorgesehen sein, faseroptische Sensoren auf Stromschienen, beispielsweise Stromschienen einer Schaltanlage, zu montieren. Im Normalbetrieb kann durch einen sinusförmigen Spannungsverlauf (und Stromfluss) mit einer Frequenz von 50 Hz eine mechanische Schwingung in den Stromschienen angeregt werden, die sich als 100 Hz Signal erfassen lässt. Ein sinusförmiger Spannungsverlauf mit einer anderen Frequenz, beispielsweise einer Netzfrequenz, kann eine mechanische Schwingung in den Stromschienen anregen, die sich als Signal mit der doppelten Frequenz dieser Frequenz des sinusförmigen Spannungsverlaufs erfassen lässt. Beispielsweise kann der sinusförmige Spannungsverlauf eine Frequenz aufweisen, welche in den USA eine Netzfrequenz von 60 Hz, bei einer Bahnanwendung 16,666 Hz oder im Bereich der Avionik 400 Hz beträgt. Die Frequenz der angeregten mechanischen Schwingung kann dann das Doppelte der entsprechenden anregenden Frequenz betragen. Mit Hilfe einer Monitoring-Hardware kann dies als Indikator für einen störungsfreien Betrieb gesehen werden.

Im Kurzschlussfall wird die überwachte Stromschiene nicht mehr mit einer einzelnen, konstanten Frequenz, sondern mit einem breiten Frequenzspektrum mechanisch angeregt, wobei die Spektrallinien erhebliche Amplituden aufweisen können. Dies kann durch ein Monitoringsystem ebenfalls erkannt und genutzt werden, um intervenierende Maßnahmen oder Analyseverfahren zur Zustandsbestimmung auszulösen.

Mit dem offenbarungsgemäßen Verfahren können bei einem Kurzschluss deutlich kürzere Reaktionszeiten ermöglicht sein, als mit Verfahren nach dem Stand der Technik. Hierdurch kann es ermöglicht sein, im Kurzschlussfall erhebliche Schäden an Betriebsmitteln und/oder Personenschäden durch rechtzeitiges intervenieren zu vermeiden.

**Patentansprüche**

1. Verfahren zum Bestimmen eines Kurzschlusses mit Auftreten eines Lichtbogens an einem elektrischen Leiter (10), aufweisend:

- Erfassen eines Messsignals für einen elektrischen Leiter (10) mittels einer Sensoreinrichtung (11), die einen Sensor (12) aufweist; und
- Vergleichen des Messsignals mit einem Referenzsignal mittels einer Auswerteeinrichtung (13); und
- Bestimmen eines Kurzschlusses mit Auftreten eines Lichtbogens mittels der Auswerteeinrichtung (13) unter Verwendung des Ergebnisses des Vergleichs des Messsignals mit dem Referenzsignal,
**dadurch gekennzeichnet, dass** das Messsignal für den elektrischen Leiter (10) und das Referenzsignal wenigstens eine Art von Messsignalen aus der folgenden Gruppe umfassen: Vibrationssignale und Schallsignale, welche durch eine Kraftwirkung der von dem elektrischen Leiter (10) geführten elektrischen Spannung verursacht sind,
wobei das Bestimmen eines Kurzschlusses mit Auftreten eines Lichtbogens vor dem Auftreten des Lichtbogens erfolgt.

2. Verfahren nach Anspruch 1, **dadurch gekennzeichnet, dass** das Messsignal mit Hilfe eines faseroptischen Sensors erfasst wird.

3. Verfahren nach Anspruch 1 oder 2, **dadurch gekennzeichnet, dass** die Sensoreinrichtung (11) direkt auf dem elektrischen Leiter (10) angeordnet ist.

4. Verfahren nach mindestens einem der vorhergehenden Ansprüche, dadurch **ge- kennzeichnet**, dass das Messsignal mit Hilfe von mehreren Sensoren (12) erfasst wird.

5. Verfahren nach mindestens einem der vorhergehenden Ansprüche, **dadurch gekennzeichnet, dass** ein Kurzschluss mit Auftreten eines Lichtbogens bestimmt wird, wenn das Messsignal dem Referenzsignal nicht entspricht.

6. Verfahren nach mindestens einem der Ansprüche 1 bis 4, dadurch **gekenn- zeichnet**, dass ein Kurzschluss mit Auftreten eines Lichtbogens bestimmt wird, wenn das Messsignal dem Referenzsignal entspricht.

7. Verfahren nach mindestens einem der vorhergehenden Ansprüche, dadurch **ge- kennzeichnet**, dass das Messsignal und das Referenzsignal anhand eines jeweiligen Merkmals des Messsignals und des Referenzsignals verglichen werden.

8. Verfahren nach Anspruch 7, **dadurch gekennzeichnet, dass** das Messsignal und das Referenzsignal anhand eines jeweiligen Merkmals verglichen werden, welches mittels mindestens eines Mitglieds der Gruppe Fourier-Transformation, Kurzzeit-Fourier-Transformation, Wavelet-Transformation, Template-Matching, Spektrogramm, Amplitudenerfassung, Hüllkurvenerfassung und digitaler Filter bestimmt wird.

9. Verfahren nach mindestens einem der vorhergehenden Ansprüche, **dadurch gekennzeichnet, dass** unter Verwendung des Ergebnisses des Vergleichs des Messsignals mit dem Referenzsignal eine Amplitude eines Kurzschlussstroms bestimmt wird.

10. Verfahren nach mindestens einem der vorhergehenden Ansprüche, **dadurch gekennzeichnet, dass** unter Verwendung des Ergebnisses des Vergleichs des Messsignals mit dem Referenzsignal ein Betriebszustand des elektrischen Leiters (10) bestimmt wird.

11. Verfahren nach mindestens einem der vorhergehenden Ansprüche, **dadurch gekennzeichnet, dass** in Reaktion auf das Bestimmen eines Kurzschlusses mit Auftreten eines Lichtbogens ein elektrisches Betriebsmittel aktiviert wird.

12. Anordnung mit:

    - einem elektrischen Leiter (10);
    - einer Sensoreinrichtung (11), die einen Sensor (12) aufweist und eingerichtet ist, ein Messsignal für den elektrischen Leiter (10) zu erfassen; und
    - einer Auswerteeinrichtung (13), die eingerichtet ist,

        - das Messsignal mit einem Referenzsignal zu vergleichen; und
        - unter Verwendung des Ergebnisses des Vergleichs des Messsignals mit dem Referenzsignal einen Kurzschluss mit Auftreten eines Lichtbogens zu bestimmen,

    wobei

        - das Messsignal für den elektrischen Leiter (10) und das Referenzsignal wenigstens eine Art von Messsignalen aus der folgenden Gruppe umfassen: Vibrationssignale und Schallsignale, welche durch eine Kraftwirkung der von dem elektrischen Leiter (10) geführten elektrischen Spannung verursacht sind, und
        - die Auswerteeinrichtung (13) eingerichtet ist, einen Kurzschluss mit Auftreten eines Lichtbogens vor dem Auftreten des Lichtbogens zu bestimmen.

**Claims**

1. A method for determining a short circuit with the occurrence of an arc on an electrical conductor (10), comprising:

    - detecting a measurement signal for an electrical conductor (10) by means of a sensor device (11) which has a sensor (12); and
    - comparing the measurement signal with a reference signal by means of an evaluation device (13); and
    - determining a short circuit with the occurrence of an arc by means of the evaluation device (13) using the result of the comparison of the measurement signal with the reference signal, **characterised in that** the measurement signal for the electrical conductor (10) and the reference signal comprise at least one type of measurement signal from the following group: vibration signals and sound signals which are caused by the force effect of the electrical voltage carried by the electrical conductor (10), wherein the determination of a short circuit with the occurrence of an arc takes place before the occurrence of the arc.

2. The method according to Claim 1, **characterised in that** the measurement signal is detected by means of a fibre optic sensor.

3. The method according to Claim 1 or 2, **characterised in that** the sensor device (11) is arranged directly on the electrical conductor (10).

4. The method according to at least one of the preceding claims, **characterised in that** the measurement signal is detected by means of a plurality of sensors (12).

5. The method according to at least one of the preceding claims, **characterised in that** a short circuit with the occurrence of an arc is determined if the measurement signal does not correspond to the reference signal.

6. The method according to at least one of Claims 1 to 4, **characterised in that** a short circuit with the occurrence of an arc is determined if the measurement signal corresponds to the reference signal.

7. The method according to at least one of the preceding claims, **characterised in that** the measurement signal and the reference signal are compared using one respective feature of the measurement signal and the reference signal.

8. The method according to Claim 7, **characterised in**

**that** the measurement signal and the reference signal are compared using one respective feature which is determined by means of at least one member of the group: Fourier transformation, short-term Fourier transformation, wavelet transformation, template matching, spectrogram, amplitude detection, envelope detection and digital filters.

9. The method according to at least one of the preceding claims, **characterised in that** an amplitude of a short circuit current is determined using the result of the comparison of the measurement signal with the reference signal.

10. The method according to at least one of the preceding claims, **characterised in that** an operating state of the electrical conductor (10) is determined using the result of the comparison of the measurement signal with the reference signal.

11. The method according to at least one of the preceding claims, **characterised in that** an electrical operating means is activated in response to the determination of a short circuit with the occurrence of an arc.

12. An arrangement comprising:

   - an electrical conductor (10);
   - a sensor device (11) which has a sensor (12) and which is configured to detect a measurement signal for the electrical conductor (10); and
   - an evaluation device (13) which is configured

      - to compare the measurement signal with a reference signal; and
      - to determine a short circuit with the occurrence of an arc using the result of the comparison of the measurement signal with the reference signal,

   wherein

      - the measurement signal for the electrical conductor (10) and the reference signal comprise at least one type of measurement signal from the following group: vibration signals and sound signals which are caused by the force effect of the electrical voltage carried by the electrical conductor (10), and
      - the evaluation device (13) is configured to determine a short circuit with the occurrence of an arc before the occurrence of the arc.

**Revendications**

1. Procédé pour déterminer un court-circuit avec apparition d'un arc électrique sur un conducteur électrique (10), comprenant de :

      - détecter un signal de mesure pour un conducteur électrique (10) au moyen d'un dispositif de capteur (11) comportant un capteur (12); et
      - comparer le signal de mesure avec un signal de référence au moyen d'un dispositif d'évaluation (13) ; et
      - déterminer d'un court-circuit avec apparition d'un arc électrique au moyen du dispositif d'évaluation (13) à partir du résultat de la comparaison du signal de mesure avec le signal de référence,

   **caractérisé en ce que** le signal de mesure pour le conducteur électrique (10) et le signal de référence comprend au moins un type de signaux provenant du groupe suivant : les signaux de vibration et les signaux sonores, qui sont provoqués par un effet de force de la tension électrique transportée par le conducteur électrique (10),

   dans lesquels la détermination d'un court-circuit avec apparition d'un arc électrique a lieu avant l'apparition de l'arc électrique.

2. Procédé selon la revendication 1, **caractérisé en ce que** le signal de mesure est détecté à l'aide d'un capteur à fibre optique.

3. Procédé selon la revendication 1 ou 2, **caractérisé en ce que** le dispositif de capteur (11) est disposé directement sur le conducteur électrique (10).

4. Procédé selon une au moins des revendications précédentes, **caractérisé en ce que** le signal de mesure est détecté à l'aide d'une pluralité de capteurs (12).

5. Procédé selon une au moins des revendications précédentes, **caractérisé en ce qu'**un court-circuit avec apparition d'un arc électrique est déterminé si le signal de mesure ne correspond pas au signal de référence.

6. Procédé selon au moins une des revendications 1 à 4, **caractérisé en ce qu'**un court-circuit avec apparition d'un arc électrique est déterminé lorsque le signal de mesure correspond au signal de référence.

7. Procédé selon au moins une des revendications précédentes, **caractérisé en ce que** le signal de mesure et le signal de référence sont comparés sur la base d'une caractéristique respective du signal de mesure et du signal de référence.

**8.** Procédé selon la revendication 7, **caractérisé en ce que** le signal de mesure et le signal de référence sont comparés à l'aide d'une caractéristique respective, qui est déterminée au moyen d'au moins un membre du groupe transformée de Fourier, transformée de Fourier à court terme, transformée en ondelettes, adaptation de modèle, spectrogramme, détection d'amplitude, détection d'enveloppe et filtre numérique.

**9.** Procédé selon au moins une des revendications précédentes, **caractérisé en ce qu'**une amplitude d'un courant de court-circuit est déterminée à partir du résultat de la comparaison du signal de mesure avec le signal de référence.

**10.** Procédé selon au moins une des revendications précédentes, **caractérisé en ce qu'**à l'aide du résultat de la comparaison du signal de mesure avec le signal de référence, un état de fonctionnement du conducteur électrique (10) est déterminé.

**11.** Procédé selon au moins une des revendications précédentes, **caractérisé en ce que** l'équipement électrique est activé en réponse à la détermination d'un court-circuit avec apparition d'un arc électrique.

**12.** Agencement comportant :

- un conducteur électrique (10) ;
- un dispositif capteur (11) qui comporte un capteur (12) et est configuré pour détecter un signal de mesure pour le conducteur électrique (10) ; et
- un dispositif d'évaluation (13) qui est configuré pour
- comparer le signal de mesure avec un signal de référence ; et
- déterminer un court-circuit avec apparition d'un arc électrique à l'aide du résultat de la comparaison du signal de mesure avec le signal de référence,

dans lequel

- le signal de mesure pour le conducteur électrique (10) et le signal de référence comprennent au moins un type de signal de mesure du groupe suivant : signaux de vibration et signaux sonores, qui sont provoqués par une force provenant de la tension électrique guidée par le conducteur électrique (10) et
- le dispositif d'évaluation (13) est configuré pour déterminer un court-circuit avec apparition d'un arc électrique avant qu'il ne se produise.

Fig. 1

Fig. 2

Fig. 3

Fig. 4

Fig. 5

Fig. 6

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2010321838 A1
- FR 2827675 A1
- US 2018074112 A1
- DE 102015225484 A1